# EUROPÄISCHE PATENTSCHRIFT

(11) **EP 1 525 485 B1**
(45) Veröffentlichungstag und Bekanntmachung des Hinweises auf die Patenterteilung: **31.10.2007**
(21) Anmeldenummer: 03787717.2
(22) Anmeldetag: 22.07.2003
(51) Int. Cl.: G01R 19/165

(54) **ADAPTIVE SPANNUNGSÜBERWACHUNG**
ADAPTIVE VOLTAGE MONITORING ARRANGEMENT
ENSEMBLE ADAPTATIF DE SURVEILLANCE DE TENSION

(30) Priorität: 26.07.2002 DE 10234181
(43) Veröffentlichungstag der Anmeldung: 27.04.2005
(73) Patentinhaber: Infineon Technologies AG, 81669 München (DE)
(72) Erfinder: WEDER, Uwe, 84072 Au/Hallertau (DE)
(74) Vertreter: Epping - Hermann - Fischer
(86) Internationale Anmeldenummer: PCT/DE2003/002468
(87) Internationale Veröffentlichungsnummer: WO 2004/017078

(56) Entgegenhaltungen:
- EP-A- 0 937 988
- JP-A- 58 118 967
- JP-A- 60 211 370
- US-A1- 2002 079 933

## Beschreibung

Die Erfindung betrifft eine adaptive Spannungsüberwachung gemäß Patentanspruch 1.

In vielen Fällen elektronischer Schaltungen ist für deren korrekte Funktion notwendig, daß die Betriebsspannung überwacht wird. In den Fällen, in denen ein zulässiger Betriebsspannungsbereich über- oder unterschritten wird, wird dann ein Fehlfunktionssignal erzeugt und weitergeleitet oder die ganze Schaltung außer Betrieb gesetzt. Heutzutage gibt es zunehmend Schaltungen, die für unterschiedliche Betriebsspannungen arbeiten. Der zulässige Betriebsbereich wird regelmäßig in Prozent einer Nennspannung angegeben. Eine derartige Nennspannung darf natürlich eine gewisse Schwankung aufweisen. Ist beispielsweise eine Schwankung von 10 Prozent zugelassen, so darf in einem 5 Volt-Bereich die Spannung zwischen 4,5 und 5,5 Volt schwanken. Gemäß einschlägiger Normen wie beispielsweise ETSI, GSM, ISO, ist beispielsweise vorgesehen, daß nunmehr für einen Chip, der im 5; 3; 1,8 V-Bereich arbeitet, der ganze Spannungsbereich von 5,5 bis 1,62 Volt zugelassen ist. Entsprechend sind bei der von außen anliegenden Versorgungsspannung Spannungswechsel, sogenannte Spannungsspikes, über einen sehr hohen Bereich möglich. Große Spannungsschwankungen wiederum können dazu führen, daß Schaltungen fehlerhaft arbeiten, was wiederum problematisch ist.

Aus dem Dokument JP 60 211 370 ist eine Anordnung bekannt, bei der eine zu überwachende Spannung mittels eines Spannungsteilers geteilt wird und die Teilspannungen als Vergleichspannungen herangezogen werden. Sobald die zu überwachende Spannung unter einen ersten Pegel fällt, wechselt ein Ausgangssignal eines ersten Operationsverstärkers. Wenn die Spannung unter einen zweiten Pegel fällt, wechselt an einem zweiten Operationsverstärker ein Ausgangssignal. Diese beiden Signale werden von einer Überwachungsschaltung überprüft. Mit dieser beschriebenen Anordnung kann überprüft werden, ob eine Spannung in einen kritischen Bereich fällt, um einen Warnzustand auszulösen und immer dann, wenn die Spannung unterhalb des kritischen Bereiches liegt wird erkannt, dass ein Betrieb insgesamt nicht mehr möglich ist und ein Ausschalten veranlasst.

Im Dokument US 2002/0079933 werden zwei Referenzspannungen definiert, die sich getrennt einstellen lassen als Funktion der Versorgungsspannung und ihrer Kennlinien.

Der Erfindung liegt daher die Aufgabe zugrunde, eine Spannungsüberwachungsanordnung vorzusehen, bei der mit einfachen Mitteln das Auftreten großer Spannungsschwankungen unterbindbar ist.

Diese Aufgabe wird erfindungsgemäß mit den in Patentanspruch 1 angegebenen Maßnahmen gelöst.

Es ist vorgesehen, daß die Spannungsüberwachungsanordnung eine der vorgegebenen Anzahl an Spannungsbereichen entsprechenden Anzahl von Vergleichseinrichtungen aufweist, die den Wert einer Eingangsspannung mit einer Bezugsspannung vergleichen und ein vorgegebenes Signal ausgeben, wenn die Eingangsspannung innerhalb eines vorgegebenen Spannungsbereiches liegt. Weiterhin ist eine Feststellschaltung vorgesehen, die bei Anliegen eines Feststellsignals feststellt, in welchem Spannungsbereich die Eingangsspannung beim Anlegen des Feststellsignals gerade liegt. Weiterhin ist eine Überwachungseinheit vorgesehen, die ein vorbestimmtes Signal abgibt, wenn die Eingangsspannung außerhalb des bei Anliegen des Feststellsignals vorliegenden Spannungsbereiches liegt.

Hierdurch ist sichergestellt, daß grundsätzlich ein breiter Spannungsbereich zulässig ist, aber zu einem bestimmten Zeitpunkt, beispielsweise wenn das Auftreten von Fehlfunktionen problematisch ist, ist ein Einschränken des zulässigen Spannungsbereiches durchführbar. Auf diese Weise kann dann, wenn innerhalb eines kritischen Zeitraumes die zugelassene eingeschränkte Spannungsgrenzen überschritten werden, von der Überwachungseinheit ein Alarmsignal oder ein Rücksetzen der Schaltung beispielsweise abgegeben werden.

Weitere vorteilhafte Ausgestaltungen der Erfindung sind in den untergeordneten Ansprüchen angegeben.

Nachfolgend wird die Erfindung unter Bezugnahme auf die Zeichnung anhand von Ausführungsbeispielen näher beschrieben.
Es zeigen:
Figur 1 ein erstes Ausführungsbeispiel der Spannungsüberwachungsanordnung im Blockschaltbild und
Figur 2 eine prinzipielle Realisierung des Ausführungsbeispiels für 3 zugelassene Spannungsbereiche.

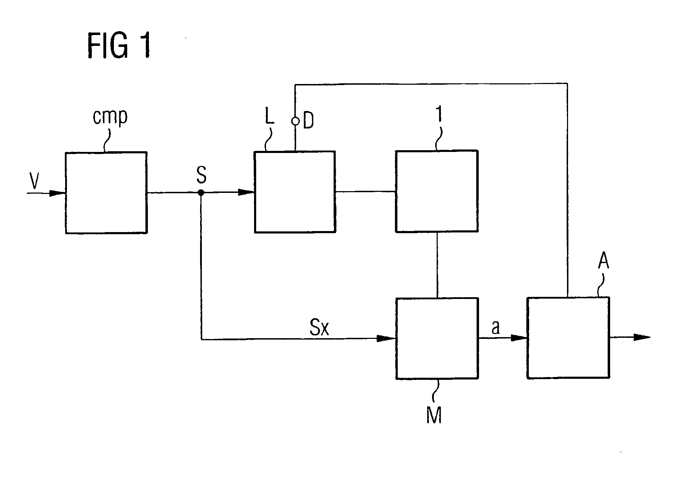

Nachfolgend wird unter Bezugnahme auf Figur 1 zunächst die grundsätzliche Funktionsweise eines Ausführungsbeispiels der Spannungsüberwachungsanordnung dargestellt. Einer Vergleichseinrichtung CMP wird eine zu überwachende Spannung V zugeführt. Je nachdem, ob die zu überwachende Spannung innerhalb eines vorgegebenen Bereiches liegt, gibt die Vergleichseinrichtung ein entsprechendes Signal S einer Auswertschaltung ab. Liegt am Eingang D der Feststellschaltung L ein vorbestimmtes Signal an, hält die Feststellschaltung L das gerade anliegende Signal S fest und gibt es als Ausgangssignal an eine Überwachungslogik 1 weiter. Die Überwachungslogik 1 ermittelt, ob die Spannung V in einem der Spannungsbereiche liegt, deren Bereichsgrenzen von der Vergleichseinrichtung CMP überwacht wird. Weiterhin steuert die Überwachungslogik 1 eine Weitergabeschaltung M derart an, daß die Signalisierung der Vergleichseinrichtung CMP für den ermittelten Spannungsbereich von der Überwachungslogik an eine Auswerteeinheit A weitergeleitet wird. Die Auswerteeinheit A überwacht nunmehr die Signalisierung für den ermittelten Spannungsbereich, um festzustellen, ob die Spannung V innerhalb der festgesetzten Spannungsgrenzen bleibt. Sobald die Überwachungseinheit A feststellt, daß der ermittelte Spannungsbereich verlassen wird, wird ein entsprechendes Signal ausgegeben, das beispielsweise die Gesamtanordnung sperrt oder ein Rücksetzen veranlaßt.

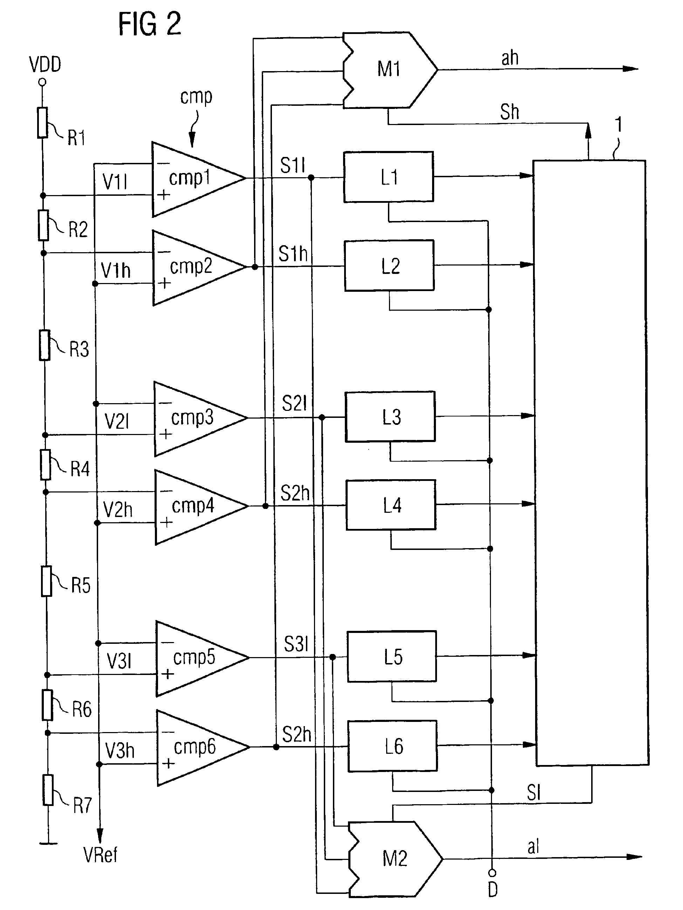

Figur 2 zeigt in einem ausführlichen Beispiel eine Spannungsüberwachungsanordnung für drei Spannungsbereiche z.B. 5;3 und 1,8 V. Eine zu überwachende Eingangsspannung VDDP, die über der Serienschaltung der Widerstände R1 bis R7 anliegt, ist zu überwachen. Dabei ist vorgesehen, daß die Spannung VDDP grundsätzlich in einem von drei Spannungsbereichen liegen soll. Die Widerstände sind nunmehr so gewählt, daß je nachdem in welchem der drei Spannungsbereiche die Spannung VDDP liegt, der Spannungsabfall am Widerstand R2, am Widerstand R4 oder am Widerstand R6 einem bestimmten Wert entsprechen, der mit einer Referenzspannung Vref verglichen wird.

Das Spannungspotential zwischen dem Widerstand R2 und Widerstand R1 wird entsprechend dem positiven Signaleingang des Komparators CMP 1 und das Potential zwischen dem Widerstand R2 und dem Widerstand R3 dem negativen Signaleingang des Komparators CMP 2 zugeführt. Dem negativen Signaleingang des Komparators CMP 1 und dem positivem Signaleingang des Komparators CMP 2 wird jeweils die Bezugsspannung Vref zugeführt. Liegt die Spannung VDDP innerhalb der niedrigsten der drei Spannungsbereiche, also z.B. 1,8 V, so liegt an den Ausgängen der beiden Komparatoren CMP 1 und CMP 2 jeweils das digitale Signal "1" an. Entsprechend wird das Potential zwischen dem Widerstand R3 und dem Widerstand R4 dem Komparator CMP 3 an seinem positivem Signaleingang und das Potential zwischen dem Widerstand R4 und dem Widerstand R5 dem negativen Signaleingang des Komparators CMP 4 zugeführt. Liegt die Spannung VDDP im mittleren der drei Spannungsbereiche, so wird an den Ausgängen dieser beiden Komparatoren ein digitales Signal "1" jeweils abgegeben. Entsprechend wird das Potential zwischen dem Widerstand R5 und dem Widerstand R6 dem positiven Signaleingang des Komparators CMP 5 und das Potential zwischen dem Widerstand R6 und dem Widerstand R7 dem negativen Signaleingang des Komparators CMP 6 zugeführt. Liegt die zu überwachende Spannung VDDP im höchsten der drei vorgesehenen Spannungsbereiche z.B. 5 V, so wird von den beiden Komparatoren CMP 5 und CMP 6 am Ausgang das digitale Signal "1" jeweils abgegeben.
Während die Komparatoren, die den Spannungsbereich signalisieren, innerhalb dessen die zu überwachende Spannung VDDP liegt, an ihrem Ausgang ein digitales Signal "1" ausgeben, geben die jeweiligen anderen Komparatoren ein digitales Signal "0" aus. Mit einer entsprechend umgekehrten Logik ist auch eine umgekehrte Signalisierung durchführbar.
Das Ausgangssignal der Komparatoren CMP 1 bis CMP 6 wird als Signale S1L, S1H, S2L, S2H, S3L, S3H "Latch"-Schaltungen L1 bis L6 zugeführt. Wird über die Signalleitung D ein Signal den "Latch"-Schaltungen L1 bis L6 zugeführt, so wird das gerade anliegende Signal, das nur "1" oder "0" sein kann, bis zur nächsten Signalisierung gehalten und am Ausgang ausgegeben. Die Ausgänge der "Latch"-Schaltungen L1 bis L6 sind einer Überwachungslogik 1 zugeführt. Diese überwacht nunmehr die Ausgangssignale der "Latch"-Schaltungen L1 bis L6 und ermittelt, an welchen Ausgängen ein digitales Signal "1" anliegt. Diese entsprechen dem ermittelten Spannungsbereich zum Zeitpunkt der Übertragung eines Signals über die Leitung D. Entsprechend wird über Steuerleitungen SH und SL ein Multiplexer M1 und ein Multiplexer M2 angesteuert, die das Ausgangssignal der dem Spannungsbereich zugeordneten Komparatoren CMP 1 bis CMP 6 weiterleiten. Das Ausgangssignal dieser Komparatoren wird nunmehr als Überwachungssignal für die obere bzw. untere Grenze ah bzw. al vom Multiplexer M1 bzw. M2 der Überwachungseinrichtung A, die nur in Fig. 1 dargestellt ist, zugeführt. Diese kann nunmehr immer dann, wenn es notwendig ist, bei einem Verlassen des ermittelten Spannungsbereiches ein Alarmsignal, ein Rücksetzen der Gesamtschaltung oder ähnliches einleiten.

Mit der beschriebenen Anordnung ist folglich immer anfangs der gesamte zulässige Spannungsbereich offen. Nach der Detektion wird der Bereich automatisch über die Multiplexer M1, M2 begrenzt.

Dadurch, daß durch den eingangsseitigen Spannungsteiler, für jeden vorgegebenen Spannungsbereich an einem der vorgegebenen Widerstände R1 bis R7 eine Spannung abfällt, die mit stets der selben Bezugsspannung Vref verglichen wird, ist für jeden der vorgegebenen Spannungsbereiche die zugelassene relative Schwankung einheitlich einstellbar.

Zeigt der gesamte Spannungsbereich zwischen 5,5 V und 1,62 V, so können Spannungsspitzen, sogenannte "Spikes" 3,88 V betragen. Ist der Bereich in der beschriebenen Weise eingeschränkt, so können im 1,8 V-Bereich, der von 1,98 V bis 1,62 V geht, nur Spannungsspitzen von 0,36 V in zugelassener Weise auftreten.

Die Erfindung ist natürlich nicht auf drei Spannungsbereiche bzw. die dargestellte Anordnung eingeschränkt. Auch das Vorsehen weniger Spannungsbereiche oder mehr Spannungsbereiche bzw. Schaltungsvarianten, die prinzipiell gleichartig arbeiten, sind selbstverständlich von der Erfindung umfaßt.

### Bezugszeichenliste

CMP Vergleichseinrichtung, Komparator
L Feststellschaltung, Latch-Schaltung
1 Überwachungslogik
M Weitergabeschaltung, Multiplexer
V, VDDP zu überwachende Spannung
A Auswerteeinheit
D Eingang der Feststellschaltung

## Patentansprüche

1. Spannungsüberwachungsanordnung mit einer vorgegebenen Anzahl an Spannungsbereichen entsprechenden Anzahl von Vergleichseinrichtungen (CMP; CMP 1 bis CMP 6), die den Wert einer Eingangsspannung (VDDP) mit einer Bezugsspannung (Vref) vergleicht und ein vorgegebenes Signal (S; S1L, S1H bis S3L, S3H) ausgibt, wenn die Eingangsspannung (VDDP) innerhalb eines der vorgegebenen Spannungsbereiche liegt, mit einer Feststellschaltung (L, L1 bis L6), die bei Anliegen eines Feststellsignals feststellt, in welchem Spannungsbereich die Eingangsspannung beim Anliegen des Feststellsignals gerade liegt und einer Überwachungseinheit (1,M; 1,M1, M2), die ein vorbestimmtes Signal (a; ah, al) abgibt, wenn die Eingangsspannung (VDDP) außerhalb des bei Anliegen des Feststellsignals vorliegenden Spannungsbereiches liegt.

2. Spannungsüberwachungsanordnung nach Anspruch 1,
bei dem in der Vergleichseinrichtung für jeden Spannungsbereich jeweils ein Komparator (CMP;CMP1 bis CMP6) eine von der zu überwachenden Eingangsspannung (VDDP) abgeleitete Spannung für eine obere und eine untere Spannungsgrenze mit der Bezugsspannung (Vref) vergleicht.

3. Spannungsüberwachungsanordnung nach Anspruch 2,
bei der in der Überwachungseinheit eine Weitergabeschaltung (M; M1, M2) die Ausgangssignale der Komparatoren (CMP; CMP 1 bis CMP 6) für einen ermittelten Spannungsbereich an eine Auswerteschaltung (A) abgibt.

4. Spannungsüberwachungsanordnung nach Anspruch 3,
bei der die Auswerteschaltung (A) die Ausgangssignale der Komparatoren nur zu einem vorbestimmten Zeitpunkt auswertet.

5. Spannungsüberwachungsanordnung nach Anspruch 4,
bei der die Auswerteschaltung das Ausgangssignal der Komparatoren zu einem ersten Zeitpunkt als Bezugswert speichert und in einem vorbestimmten Zeitbereich die Ausgangssignale der Komparatoren mit den Bezugswerten vergleicht.

## Claims

1. Voltage monitoring arrangement having a number of comparison devices (CMP; CMP 1 to CMP 6) which corresponds to a prescribed number of voltage ranges and compares the value of an input voltage (VDDP) with a reference voltage (Vref) and outputs a prescribed signal (S; S1L, S1H to S3L, S3H) if the input voltage (VDDP) is within one of the prescribed voltage ranges, having a latch circuit (L, L1 to L6) which, when a latch signal is applied, establishes which voltage range the input voltage is currently in when the latch signal is applied, and having a monitoring unit (1, M; 1, M1, M2) which outputs a predetermined signal (a; ah, al) if the input voltage (VDDP) is outside the voltage range which exists when the latch signal is applied.

2. Voltage monitoring arrangement according to Claim 1,
in which, for each voltage range, a respective comparator (CMP; CMP 1 to CMP 6) in the comparison device compares a voltage, derived from the input voltage (VDDP) to be monitored, for an upper and a lower voltage limit with the reference voltage (Vref).

3. Voltage monitoring arrangement according to Claim 2,
in which a forwarding circuit (M; M1, M2) in the monitoring unit outputs the output signals from the comparators (CMP; CMP 1 to CMP 6) for an ascertained voltage range to an evaluation circuit (A).

4. Voltage monitoring arrangement according to Claim 3,
in which the evaluation circuit (A) evaluates the output signals from the comparators only at a predetermined time.

5. Voltage monitoring arrangement according to Claim 4,
in which the evaluation circuit stores the output signal from the comparators at a first time as a reference value and compares the output signals from the comparators with the reference values in a predetermined time range.

## Revendications

1. Montage de contrôle de tension, comprenant un nombre de dispositifs (CMP ; CMP 1 à CMP 6) de comparaison correspondant à un nombre prescrit de domaines de tension, comparant la valeur d'une tension (VDDP) d'entrée à une tension (Vref) de référence et émettant un signal (S ; S1L, S1H à S3L, S3H) prescrit lorsque la tension (VDDP) d'entrée se trouve à l'intérieur de l'un des domaines de tension prescrits, un circuit (L ; L1 à L6) de constatation, qui constate, lorsqu'un signal de constatation est appliqué, dans quel domaine de tension la tension d'entrée se trouve précisément lors de l'application du signal de constatation et une unité (1,M ; 1,M1, M2) de contrôle, qui émet un signal (a ; ah, al) déterminé à l'avance lorsque la tension (VDDP) d'entrée se trouve à l'extérieur du domaine de tension présent lors de l'application du signal de constatation.

2. Montage de contrôle de tension suivant la revendication 1, dans lequel, dans le dispositif de comparaison pour chaque domaine de tension, respectivement un comparateur (CMP ; CMP 1 à CMP 6) compare à la tension (Vref) de référence, pour une limite de tension supérieure et une limite de tension inférieure, une tension dérivée de la tension (VDDP) d'entrée à contrôler.

3. Montage de contrôle de tension suivant la revendication 2, dans lequel, dans l'unité de contrôle, un circuit (M ; M1, M2) d'acheminement émet les signaux de sortie des comparateurs (CMP ; CMP 1 à CMP 6) pour un domaine de tension déterminé à un circuit (A) d'exploitation.

4. Montage de contrôle de tension suivant la revendication 3, dans lequel le circuit (A) d'exploitation évalue les signaux de sortie des comparateurs que jusqu'à un instant déterminé à l'avance.

5. Montage de contrôle de tension suivant la revendication 4, dans lequel le circuit d'exploitation mémorise en tant que valeur de référence le signal de sortie des comparateurs à un premier instant et, dans une plage temporelle déterminée à l'avance, compare les signaux de sortie des comparateurs aux valeurs de référence.
